# EUROPÄISCHE PATENTSCHRIFT

(11) **EP 2 198 455 B1**
(45) Veröffentlichungstag und Bekanntmachung des Hinweises auf die Patenterteilung: **24.05.2017**
(21) Anmeldenummer: 08837280.0
(22) Anmeldetag: 07.10.2008
(51) Int. Cl.: H01L 23/498

(54) **CHIPMODUL FÜR CHIPKARTE**
CHIP MODULE FOR CHIP CARD
MODULE DE PUCE POUR UNE CARTE A PUCE

(30) Priorität: 08.10.2007 DE 102007048237
(43) Veröffentlichungstag der Anmeldung: 23.06.2010
(73) Patentinhaber: Giesecke & Devrient GmbH, 81677 München (DE)
(72) Erfinder: OLBRICH, Magnus, 81543 München (DE)
(86) Internationale Anmeldenummer: PCT/EP2008/008461
(87) Internationale Veröffentlichungsnummer: WO 2009/046962

(56) Entgegenhaltungen:
- EP-A- 1 684 216
- EP-A2- 1 093 082
- WO-A2-97/34247
- US-B1- 6 446 874

## Beschreibung

Die Erfindung betrifft ein Chipmodul und ein Verfahren zum Einbauen eines Chipmoduls in eine Ausnehmung eines Chipkartenkörpers mittels eines wärmeaktivierbaren Klebstoffs sowie eine Chipkarte mit einem darin eingebauten Chipmodul. Eine solche Chipkarte ist beispielsweise in der EP 1 684 216 beschrieben. Chipmodule werden in der Regel auf einem elektrisch isolierenden Trägerband, beispielsweise auf einem Polyimid-Folienband (Handelsname: Kapton) aufgebaut und erst kurz vor ihrer Montage in einer Ausnehmung des Chipkartenkörpers aus dem Trägerband ausgestanzt. Das Trägerband dient dabei als Substrat für die Komponenten des Chipmoduls. Diejenige Seite des Substrats, welche nach dem Einbau in den Chipkartenkörper nach außen weist und daher nachfolgend als "Substratvorderseite" bezeichnet wird, ist metallisch beschichtet, wobei die Metallbeschichtung strukturiert ist, um voneinander beabstandete Kontaktflächen zur kontaktbehafteten Kontaktierung des Chipmoduls auszubilden. Die metallische Beschichtung ist in der Regel mehrschichtig und besteht aus einer untersten Kupferschicht, einer obersten Goldschicht und einer dazwischen liegenden Verbindungsschicht aus Nickel. Auf der Rückseite des Substrats ist üblicherweise der Chip des Chipmoduls befestigt. Bonddrähte führen vom Chip durch Freistanzungen in dem Substrat hindurch rückseitig an die metallische Beschichtung auf der Substratvorderseite, um die notwendige elektrische Verbindung herzustellen. Anstatt dieser sogenannten Wirebond-Technik kann der Chip auch beispielsweise als sogenannter Flipchip auf die Substratrückseite aufgesetzt und über Durchkontaktierungen durch das Substrat hindurch mit den Kontaktflächen auf der Substratvorderseite elektrisch leitend verbunden sein. Der Chip mit den Bonddrähten oder der Flipchip sind in aller Regel mit einer Vergußmasse schützend umgeben. Diese sogenannte Vergußpille befindet sich zentral auf der Substratrückseite und wird von dem Substrat mit den vorderseitig vorgesehenen Kontaktflächen deutlich überragt. Zusätzliche Kontaktflächen können auch auf der Substratrückseite vorgesehen sein, beispielsweise als Antennen- oder Spulenanschlüsse für in den Kartenkörper integrierte Antennen- oder Spulenstrukturen in sogenannten Dual-Interface-Karten oder Dual-Interface-Chipmodulen oder zu anderen Zwecken. Zum Aufbau und den Materialien von Chipmodulen wird auf "Vom Plastik zur Chipkarte", Y. Haghiri/T. Tarantino, Kapitel 6.3 verwiesen. Bei neueren Modulen wie dem FCOS-Modul der Firma IFX oder dem sogenannten CardToken von Giesecke & Devrient sind auf der Substratrückseite metallische Schaltungsstrukturen angelegt und es sind Durchkontaktierungen von der vorderen Metallbeschichtung zu den Metallisierungsstrukturen auf der Substratrückseite vorgesehen, die auch als "Vias" bezeichnet werden.

Derartige Chipmodule werden in einer Ausnehmung des Chipkartenkörpers eingeklebt, was als "Implantierung" bezeichnet wird. Dazu gibt es im wesentlichen zwei Varianten, einerseits unter Verwendung reaktiver Kleber und andererseits unter Verwendung wärmeaktivierbarer Kleber. Jede dieser Varianten hat ihre Vor- und Nachteile. Bei reaktiven Klebersystemen muß beispielsweise eine gewisse Zeit abgewartet werden, bis die Chipkarte ihre volle mechanische Stabilität entwickelt hat. Bei der Verwendung eines wärmeaktivierbaren Klebstoffs besteht die Problematik dagegen darin, die zum Aktivieren des Klebstoffs notwendige Wärme vom Chip und/ oder der Chipverkapselung fernzuhalten. Der Kleber kann als Klebeband oder als Klebstoffauftrag auf der Rückseite des Chipmodulsubstrats oder gegebenenfalls auch in der Ausnehmung des Chipkartenkörpers vorgesehen sein. Die Aktivierung des Klebers erfolgt unter Verwendung eines Heißpreßstempels von der Substratvorderseite aus, mit dem das Chipmodul in die Ausnehmung des Chipkartenkörpers eingepreßt wird.

Wird die Temperatur zu hoch oder die Prozeßzeit zu lange gewählt, kann der wärmeaktivierbare Kleber an den Seiten des Chipmoduls an die Kartenoberfläche treten und diese verschmutzen. Außerdem kann bei einer ungünstig gewählten Kombination der Prozessparameter die Kartenrückseite durch die Temperatureinwirkung stark deformiert werden. Zu hohe Temperaturspitzenbelastungen können bei Chipmodulen mit Epoxidharz-Vergußmassen zum sogenannten Popcorn-Effekt führen und das Chipmodul beschädigen. Dies wiederum kann zur Modulwölbung und zu Bonddrahtabrissen führen. Um dem Popcorn-Effekt entgegenzuwirken, sind die Heißpreßstempel im Bereich der Vergußmasse ausgespart, da die Temperatur ohnehin nur im Bereich der Klebefläche benötigt wird. Darüber hinaus ist es bekannt, die metallische Beschichtung auf der Substratvorderseite umlaufend um die Kontaktflächen herum durch Schnitte in der Metallisierung thermisch von den Kontaktflächen zu entkoppeln, so daß die über den Randbereich eingetragene Wärme nicht über die Kontaktflächen zum Chip/Chipverguß gelangt.

Wegen dieser Problematik und wegen der geringen Wärmeleitfähigkeit des Chipmodulsubstrats erfolgt das Einkleben des Chipmoduls in der Ausnehmung des Chipkartenkörpers bei relativ niedrigen Temperaturen über eine entsprechend lange Zeitdauer, um trotz der niedrigen Temperaturen die notwendige Wärmeenergie durch das Substrat hindurch auf die Substratrückseite zur dortigen Klebstoffschicht zu bringen.

Aufgabe der vorliegenden Erfindung ist es nun, das Einbauen des Chipmoduls in die Ausnehmung des Chipkartenkörpers unter Verwendung des wärmeaktivierbaren Klebstoffs in zeitlicher Hinsicht zu optimieren.

Diese Aufgabe wird durch ein Chipmodul sowie eine entsprechende Chipkarte und ein Verfahren zum Einbauen eines Chipmoduls in einen Chipkartenkörper mit den Merkmalen der nebengeordneten Ansprüche gelöst. In davon abhängigen Ansprüchen sind vorteilhafte Ausgestaltungen und Weiterbildungen der Erfindung angegeben.

Die Erfindung basiert auf dem Grundgedanken, die Wärmeenergie effektiver von der Substratvorderseite auf die Substratrückseite zu dem dort entweder am Substrat oder in der Ausnehmung des Chipkartenkörpers befindlichen Klebstoff zu leiten. Dazu wird die Substratvorderseite mit der Substratrückseite durch eine oder vorzugsweise mehrere Wärmeleitbrücken in wärmeleitender Weise verbunden. Die Wärmeleitbrücken bestehen aus einem Material, welches eine deutlich höhere Wärmeleitfähigkeit besitzt als das Material, aus welchem das Substrat des Chipmoduls besteht. Auf diese Weise wird die auf der Substratvorderseite mittels des Heißpreßstempels eingebrachte Wärme schneller von der Substratvorderseite zur Substratrückseite geleitet und erwärmt den dort befindlichen wärmeaktivierbaren Klebstoff.

Insgesamt ist deutlich weniger Energie erforderlich, um den Klebstoff zu aktivieren, da der Wärmeverlust ins Substratmaterial hinein deutlich reduziert ist. Dadurch können die Verarbeitungszeiten verkürzt werden. Weil die Verarbeitungszeiten verkürzt werden, heizt sich das Substratmaterial entsprechend weniger auf und entsprechend weniger Wärme wird zur Vergußpille und dem darin befindlichen Chip geleitet. Konsequenter Weise kann daher auch die Temperatur des Heißpreßstempels im Vergleich zu den heutzutage üblichen Temperaturen erhöht werden und die Verarbeitungszeit dementsprechend weiter reduziert werden, da bei einer Erhöhung der Stempeltemperatur die zur Aktivierung des Klebers notwendige Wärmemenge auf der Substratrückseite früher erreicht ist.

Vorzugsweise ist der die Kontaktflächen umgebende Randbereich der Substratvorderseite mit demselben metallischen Material beschichtet, aus welchem die Kontaktflächen gebildet sind, wobei dieser Randbereich - wie schon im Stand der Technik - durch eine Unterbrechung dieser Beschichtung von den Kontaktflächen getrennt ist, um den Randbereich von den Kontaktflächen thermisch zu entkoppeln. Es ist aber genauso gut möglich, den Randbereich anders zu gestalten, insbesondere mit einem anderen, möglicherweise noch besser wärmeleitenden Material zu beschichten. In jedem Fall ist es günstig, die Wärme mittels des Heißpreßstempels zumindest hauptsächlich in diesem thermisch entkoppelten Randbereich der metallischen Beschichtung aufzubringen und dementsprechend die Wärmeleitbrücken auch nur in diesem Randbereich anzuordnen. Die Erfindung ist aber gleichermaßen anwendbar, wenn die Wärmeleitbrücken alle oder teilweise im Bereich der Kontaktflächen liegen.

Das Material der die Substratvorderseite mit der Substratrückseite wärmeleitend verbindenden Wärmeleitbrücken besitzt vorzugsweise eine Wärmeleitfähigkeit, die mehr als 100, insbesondere mehr als 1000-mal so groß ist wie die Wärmeleitfähigkeit des Substratmaterials. Besonders geeignet sind Wärmeleitbrücken aus Metall, wobei Kupfer aus prozessökonomischen Gründen bevorzugt wird, weil auch die unterste Schicht der Kontaktflächen in der Regel aus Kupfer besteht. Es ist somit verfahrenstechnisch ideal, die Wärmeleitbrücken aus demselben Material zu fertigen wie die Kontaktflächen auf der Substratvorderseite.

In einer bevorzugten Ausführungsform werden die Wärmeleitbrücken zwischen der Substratvorderseite und der Substratrückseite durch das Substrat selbst hindurchgeführt, ähnlich wie die eingangs genannten Vias. Es kann somit zur Erzeugung der Wärmeleitbrücken auf bereits bestehende Fertigungstechnologien zurückgegriffen werden. Die Wärmeleitbrücken können aber auch um das Substrat herumgeführt werden.

Vorzugsweise sind die Wärmeleitbrücken auf der Substratrückseite mit dort speziell ausgebildeten Wärmeübertragungszonen wärmeleitend verbunden, die ebenfalls aus einem Material mit höherer Wärmeleitfähigkeit als das Substratmaterial bestehen, insbesondere also wieder aus Kupfer. So wie die Wärmeeinbringungsbereiche auf der Substratvorderseite im Randbereich und thermisch getrennt zu den Kontaktflächen vorgesehen sind, so sind auch die Wärmeübertragungszonen auf der Substratrückseite zweckmäßig von der Vergußpille und etwaigen zum Chip führenden elektrischen Leiterbahnen beabstandet.

Besonders effizient lässt sich die Erfindung in einem Chipmodul realisieren, bei dem elektrische Leiterbahnen oder Anschlüsse auf der Substratrückseite ohnehin vorgesehen sind. Denn diese Leiterbahnen und Anschlüsse bestehen üblicherweise aus einem elektrisch leitfähigen Material, welches gleichzeitig eine hohe Wärmeleitfähigkeit besitzt, insbesondere aus einem Metall. Die Wärmeübertragungszonen auf der Substratrückseite können dann aus demselben Material bzw. Metall wie die elektrischen Leiterbahnen/ Anschlüsse, jedoch getrennt von diesen ausgebildet werden. Die Wärmeleitbrücken setzen sich somit auf der Substratrückseite in Pseudoleiterbahnen fort, die nicht der elektrischen Leitung beim Betrieb des Chipmoduls bzw. der damit ausgestatteten Chipkarte sondern allein der Temperaturverteilung dienen.

Da die Klebekräfte zwischen dem Klebstoff und den metallischen Wärmeübertragungszonen gering sind und die eigentliche Klebeverbindung zwischen dem Klebstoff und dem Substrat hergestellt werden soll, sollten die Wärmeübertragungszonen die zu verklebende Substratunterseite nicht vollständig bedecken. Zur Erzielung einer optimalen Temperaturverteilung wird daher das Layout der Wärmeübertragungszonen entsprechend angepasst. Bevorzugt werden beispielsweise Wärmeübertragungszonen in Mäanderform oder in Form von sich nebeneinander erstreckenden Streifen, die jeweils mit mindestens einer Wärmeleitbrücke verbunden sind. Die Streifen können unterschiedlich lang sein, um die Wärme von den im Randbereich des Chipmoduls angeordneten Wärmeleitbrücken möglichst gleichmäßig an alle Stellen auf der Substratrückseite bis nahe an die Vergußpille zu leiten.

Nachfolgend wird die Erfindung beispielhaft anhand der begleitenden Zeichnungen erläutert. Darin zeigen:
- Figur 1: ein Chipmodul schematisch in perspektivischer Ansicht von oben zusammen mit einem darüber schwebenden Heißpreßstempel,
- Figur 2: ein erfindungsgemäßes Chipmodul schematisch beim Einsetzen in eine Ausnehmung eines Chipkartenkörpers,
- Figur 3A, 3B: die Wärmeverteilung im Chipmodulsubstrat nach dem Stand der Technik und gemäß der Erfindung,
- Figur 4A: das Chipmodul aus Figur 2 schematisch in Draufsicht und
- Figur 4B: das Chipmodul aus Figur 2 schematisch in Ansicht von unten.

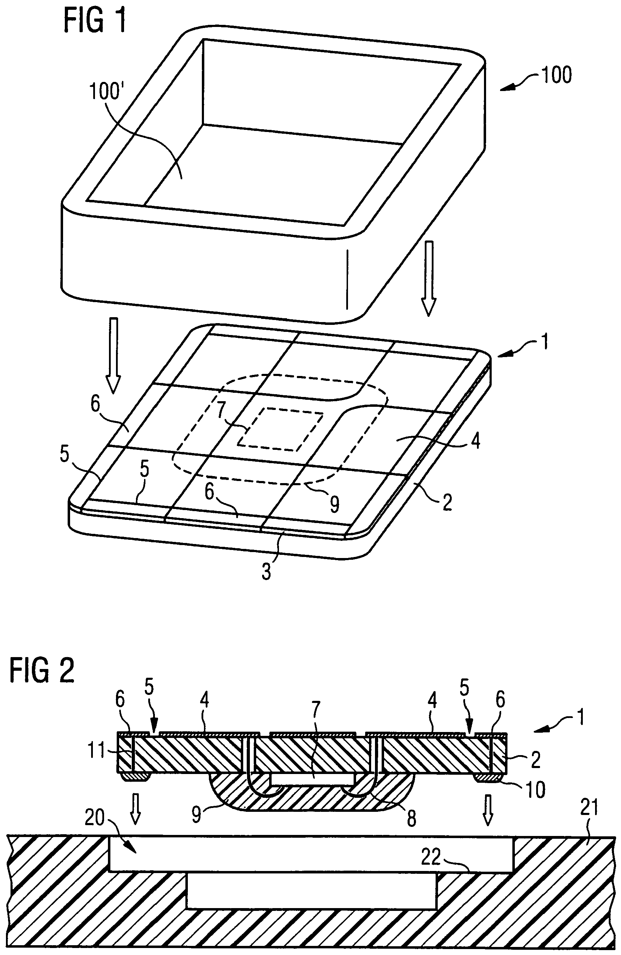

In Figur 1 ist ein Chipmodul 1 schematisch in perspektivischer Ansicht von oben mit einem darüber schwebenden Heißpreßstempel 100 dargestellt. Das Chipmodul 1 umfaßt ein Substrat 2 mit einer metallischen Beschichtung 3 auf der Substratvorderseite. Die metallische Beschichtung bildet im zentralen Bereich der Substratvorderseite acht um ein Zentrum herum angeordnete Kontaktflächen 4 aus. Schnitte 5 in der metallischen Beschichtung 3, die in etwa parallel zu den Seitenkanten des Moduls verlaufen, trennen einen Randbereich 6 von den Kontaktflächen 4 ab. Durch die Schnitte 5 ist der Randbereich 6 von den Kontaktflächen 4 thermisch entkoppelt. In einer Variante kann der Randbereich 6 auch ganz oder teilweise zusammenhängend mit den aus der metallischen Beschichtung 3 herausgebildeten Kontaktflächen 4 ausgebildet sein. Der Heißpreßstempel 2 besitzt eine zentrale Aussparung 100' entsprechend der Kontur der Schnitte 5, so daß mittels des Heißpreßstempels 2 Wärme im wesentlichen nur in dem Randbereich 6 auf das Chipmodul 1 übertragen wird. Der Randbereich 6 bildet dabei einen Wärmeeinleitungsbereich. Im Zentrum der Rückseite des Substrats 2 ist ein Chip 7 befestigt, der mittels Bonddrähten 8 durch das Substrat 2 hindurch (siehe dazu Figur 2) mit den Kontaktflächen 4 elektrisch leitend verbunden sein kann. Der Chip 7 und die Bonddrähte 8 sind durch eine Vergußpille 9 geschützt.

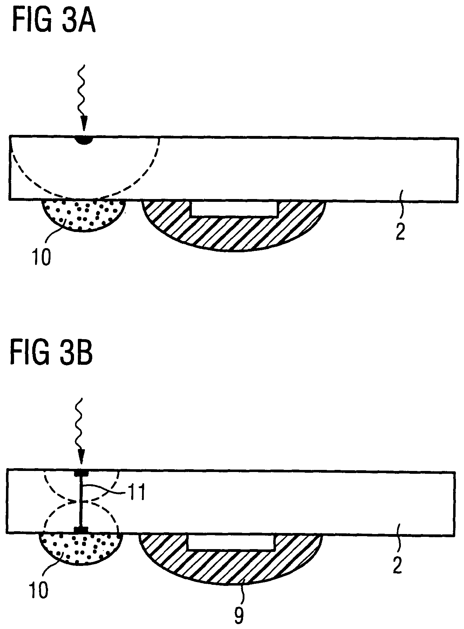

Figur 2 zeigt im Querschnitt ein prinzipiell der Figur 1 entsprechendes Chipmodul 1, welches in Draufsicht und als Ansicht von unten genauer in den Figuren 3A und 3B gezeigt ist, beim Einbau in eine Ausnehmung 20 eines Chipkartenkörpers 21. Auf der Unterseite des Substrats 2 ist ein wärmeaktivierbarer Klebstoff 10 aufgetragen. Der Klebstoff 10 kann auch als Klebstofffolie auf die Substratrückseite aufgebracht sein. Das Chipmodul 1 wird hier so in die Ausnehmung 20 des Chipkartenkörpers 21 eingesetzt, daß der Klebstoff 10 auf Schultern 22 der Ausnehmung 20 trifft. Der Klebstoff kann anstatt auf der Substratrückseite auch direkt in der Ausnehmung des Chipkartenkörpers vorgesehen werden.

Wenn dann der Heißpreßstempel 100 (Figur 1) auf das Chipmodul 1 aufgesetzt wird, wird die Wärme des Heißpreßstempels 100 durch das Substrat 2 hindurch auf die gegenüberliegende Seite geleitet, dadurch der Klebstoff 10 aktiviert und so das Chipmodul 1 auf der Schulter 22 der Ausnehmung 20 fixiert. Bei anders gestalteten Chipmodulen und Aussparungen kann eine Fixierung z.B. auch unmittelbar auf dem Boden der Aussparung erfolgen. Die leitende Wärmeübertragung durch das Substrat 2 hindurch wird durch Wärmeleitbrücken 11 unterstützt. Diese Wärmeleitbrücken 11 verbinden die Randbereiche 6 auf der Substratvorderseite unmittelbar oder ggf. auch nur mittelbar mit dem Klebstoff 10 auf der Substratrückseite.

Der dadurch erzielte Effekt wird nachfolgend anhand der Figuren 3A und 3B erläutert. Figur 3A zeigt schematisch ein herkömmliches Chipmodul mit einem Substrat 2 aus zum Beispiel Kapton. Wird nun Wärme punktförmig auf die Substratvorderseite aufgebracht, breitet sich die Wärme in dem Substrat 2 sphärisch in jede Richtung gleichmäßig aus. Es geht somit viel Wärme in dem Substrat 2 verloren, bis auf der Substratrückseite ausreichend Wärme zur Aktivierung des dortigen wärmeaktivierbaren Klebstoffs 10 angekommen ist. Wird dagegen, wie in Figur 3B gezeigt, die auf der Substratvorderseite punktförmig eingebrachte Wärme mittels einer Wärmeleitbrücke 11 direkt zum Klebstoff 10 auf die Substratrückseite geleitet, breitet sich die Wärme zwar auf der Substratvorderseite und auf der Substratrückseite (und um die Wärmeleitbrücke 11 herum) zwar ebenfalls sphärisch aus, der Wärmeverlust in dem Substrat 3 ist aber insgesamt deutlich geringer. Man erkennt auch, daß die Wärmefront deutlich weiter von der Chipvergußpille 9 entfernt bleibt.

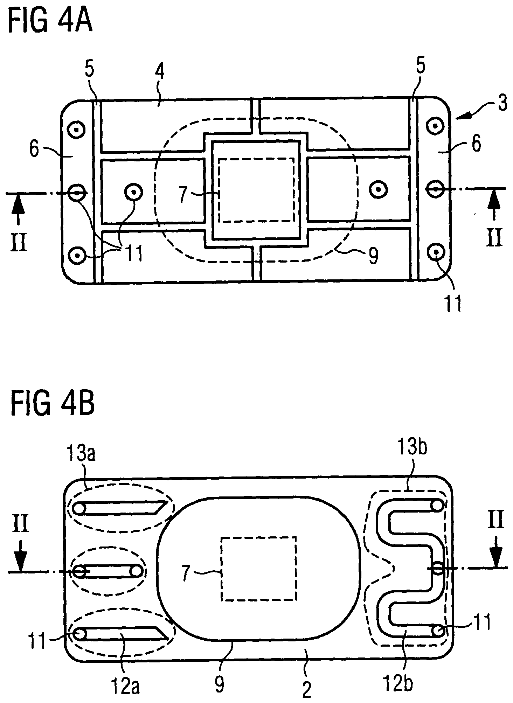

Figur 4A zeigt ein konkretes Kontaktlayout der metallischen Beschichtung 3 eines Chipmoduls in Draufsicht. Figur 4B zeigt beispielhaft dazu eine entsprechende Rückansicht des Chipmoduls. Es handelt sich dabei um ein Chipmodul, wie es in Figur 2 im Querschnitt dargestellt ist. Es sind in der metallischen Beschichtung 3 zwei gegenüberliegende Randbereiche 6 durch Trennschnitte 5 von Kontaktflächen 4 abgetrennt, um die Randbereiche 6 von dem zentralen Kontaktflächenbereich thermisch zu entkoppeln. Die Randbereiche 6 fungieren als Wärmeeinbringungsbereiche und dienen insbesondere der Wärmeeinbringung mittels des Heißpreßstempels 100. In den Randbereichen 6 sind gleichmäßig verteilt die Wärmeleitbrücken 11 angeordnet. Es können zusätzlich Wärmeleitbrücken 11 in den Kontaktflächen 4 vorgesehen sein, um Wärme aus den Kontaktflächenbereichen ebenfalls auf die Substratrückseite abzuführen. Dies ist insbesondere zweckmäßig, wenn der Heißpreßstempel 2 beim Einpressen des Chipmoduls 1 in die Ausnehmung 20 des Chipkartenkörpers 21 auch die Kontaktflächen 4 teilweise erfasst. Die Wärmeeinbringung im Bereich der Kontaktflächen 4 ist im Vergleich zum Stand der Technik wesentlich unkritischer, da aufgrund der verbesserten Wärmeübertragung von der Substratvorderseite auf die Substratrückseite mit niedrigeren Temperaturen und/ oder kürzeren Temperatureinwirkzeiten gearbeitet werden kann.

Die an die Kontaktfläche 4 angeschlossene Wärmeleitbrücke 11 kann als herkömmliches Via ausgebildet werden, dient aber im späteren Betrieb der Chipkarte nicht als elektrischer Leiter sondern nur als Wärmeleiter.

Bei dem hier dargestellten Ausführungsbeispiel enden die Wärmeleitbrükken 11 nicht einfach auf der Rückseite des Substrats 2 sondern gehen dort in speziell ausgebildete Wärmeübertragungszonen 12a und 12b über. Die Wärmeübertragungszonen 12a und 12b bestehen genau wie die Wärmeleitbrücken 11 aus einem im Vergleich zum Substratmaterial hochwärmeleitenden Material, insbesondere aus einem Metall wie Kupfer. Als Substratmaterial kann beispielsweise FR4 mit einer Wärmeleitfähigkeit von 0,3 W/mK verwendet werden. Der Wärmeleitkoeffizient von Kupfer beträgt demgegenüber 400 W/mK und liegt somit um mehr als das 1000-fache über dem von FR4.

Die Wärmeleitbrücken 11 und Wärmeübertragungszonen 12a, 12b sind so angeordnet und strukturiert, daß die auf der Substratvorderseite eingebrachte Wärme möglichst gleichmäßig zu den Klebeflächen auf der Substratrückseite geleitet wird. Die Klebeflächen sind in Figur 4B durch Strichlinien 13a bzw. 13b angedeutet. Dementsprechend können die Wärmeübertragungszonen 12a, 12b beispielsweise als sich nebeneinander erstreckende Streifen ausgebildet sein (12a, links in Figur 4B) oder mäanderförmig verlaufen (12b, rechts in Figur 4B). Andere Geometrien sind gleichfalls denkbar.

Sofern auf der Rückseite des Substrats 2 ohnehin Leiterbahnstrukturen vorgesehen sind, ist es zweckmäßig, die Wärmeübertragungszonen 12a, 12b aus demselben Material und im selben Verfahrensschritt zu erzeugen wie diese Leiterbahnstrukturen.

## Patentansprüche

1. Chipmodul (1) zum Einbau in eine Ausnehmung (20) eines Chipkartenkörpers (21) mittels eines wärmeaktivierbaren Klebstoffs (10), umfassend ein Substrat (2) mit Kontaktflächen (4) in einem zentralen Bereich der Substratvorderseite zur kontaktbehafteten Kontaktierung des Chipmoduls und mit in einem Randbereich (6) der Substratvorderseite ausgebildeten Wärmeeinbringungsbereichen zur Einbringung von Wärme in das Chipmodul (1) und desweiteren umfassend einen mit den Kontaktflächen (4) elektrisch leitend verbundenen Chip (7), **dadurch gekennzeichnet, dass**
- die Wärmeeinbringungsbereiche (6) von den Kontaktflächen (4) getrennt sind und nicht als elektrischer Leiter dienen,
- in dem Substrat (2) ein oder mehrere Wärmeleitbrücken (11) ausgebildet sind, die aus einem Material mit höherer Wärmeleitfähigkeit als das Substratmaterial bestehen, und
- die Wärmeleitbrücken (11) die Wärmeeinbringungsbereiche (6) auf der Substratvorderseite mit einer Rückseite des Substrats (2) wärmeleitend verbinden.

2. Chipmodul nach Anspruch 1, **dadurch gekennzeichnet, daß** die Wärmeeinbringungsbereiche getrennt von den Kontaktflächen (4) ausgebildet sind.

3. Chipmodul nach Anspruch 1, **dadurch gekennzeichnet, daß** die Wärmeeinbringungsbereiche dasselbe Material umfassen wie die Kontaktflächen (4), von den Kontaktflächen (4) jedoch durch eine Materialunterbrechung (5) getrennt sind.

4. Chipmodul nach einem der Ansprüche 1 bis 3, **dadurch gekennzeichnet, daß** die Wärmeleitfähigkeit des Materials der Wärmeleitbrücken (11) mehr als 100, vorzugsweise mehr als 1000 mal so groß ist wie die Wärmeleitfähigkeit des Substratmaterials.

5. Chipmodul nach einem der Ansprüche 1 bis 4, **dadurch gekennzeichnet, daß** die Wärmeleitbrücken (11) aus Metall, insbesondere Kupfer, bestehen.

6. Chipmodul nach einem der Ansprüche 1 bis 5, **dadurch gekennzeichnet, daß** die Wärmeleitbrücken (11) zwischen der Substratvorderseite und der Substratrückseite durch das Substrat (2) hindurchgeführt sind.

7. Chipmodul nach einem der Ansprüche 1 bis 6, **dadurch gekennzeichnet, daß** die Wärmeleitbrücken (11) mit auf der Substratrückseite ausgebildeten Wärmeübertragungszonen (12a, 12b), die ebenfalls aus einem Material mit höherer Wärmeleitfähigkeit als das Substratmaterial bestehen, wärmeleitend verbunden sind.

8. Chipmodul nach Anspruch 7, **dadurch gekennzeichnet, daß** die Wärmeübertragungszonen (12a, 12b) aus demselben Material bestehen, wie auf der Substratrückseite ausgebildete elektrische Leiterbahnen oder Anschlüsse, jedoch getrennt von diesen angeordnet sind.

9. Chipmodul nach einem der Ansprüche 7 oder 8, **dadurch gekennzeichnet, daß** die Wärmeübertragungszonen (12b) mäanderförmig verlaufen.

10. Chipmodul nach einem der Ansprüche 7 oder 8, **dadurch gekennzeichnet, daß** mehrere Wärmeübertragungszonen (12a) als sich nebeneinander erstreckende Streifen ausgebildet sind, die jeweils mit mindestens einer Wärmeleitbrücke (11) verbunden sind.

11. Chipmodul nach einem der Ansprüche 1 bis 10, **gekennzeichnet durch** einen wärmeaktivierbaren Klebstoff (10) auf der Substratrückseite.

12. Chipkarte, umfassend einen Kartenkörper (21) mit einer Ausnehmung (20) in der ein Chipmodul (1) angeordnet ist, welches ein Substrat (2) mit einer nach außen weisenden Vorderseite, auf der Kontaktflächen (4) zur kontaktbehafteten Kontaktierung der Chipkarte vorgesehen sind, und einer Rückseite, mittels der das Chipmodul (1) in der Ausnehmung (20) eingeklebt ist, aufweist, **dadurch gekennzeichnet, daß**
- auf der Vorderseite des Substrats (2) von den Kontaktflächen (4) getrennte Wärmeeinbringungsbereiche (6) ausgebildet sind,
- in dem Substrat ein oder mehrere Wärmeleitbrücken (11), die aus einem Material mit höherer Wärmeleitfähigkeit bestehen als das Substratmaterial, ausgebildet sind, und
- die Wärmeleitbrücken (11)die Substratvorderseite mit der Substratrückseite wärmeleitend verbinden, wobei die Wärmeleitbrücken (11) keine elektrisch leitende Funktion beim Betrieb der Chipkarte übernehmen.

13. Chipkarte nach Anspruch 12, **dadurch gekennzeichnet, daß** die Wärmeleitbrücken (11) in einem Randbereich (6) der Substratvorderseite neben den Kontaktflächen (4) angeordnet sind.

14. Chipkarte nach Anspruch 12 oder 13, **dadurch gekennzeichnet, daß** zumindest ein oder mehrere de Wärmeleitbrücken (11) im Bereich der Kontaktflächen (4) angeordnet sind.

15. Chipkarte nach einem der Ansprüche 12 bis 14, **dadurch gekennzeichnet, daß** das Chipmodul (1) ein Chipmodul gemäß einem der Ansprüche 1 bis 10 ist.

16. Verfahren zum Einbauen eines Chipmoduls (1) in eine Ausnehmung eines Chipkartenkörpers (21), wobei das Chipmodul (1) ein Substrat (2) mit einer Vorderseite, auf der Kontaktflächen (4) zur kontaktbehafteten Kontaktierung der Chipkarte sowie wenigstens einen davon getrennten Wärmeeinbringungsbereich (6) vorgesehen sind, und einer Rückseite, mittels der das Chipmodul (1) in die Ausnehmung (20) eingeklebt wird, aufweist, und ein oder mehrere, mit dem wenigstens einen Wärmeeinbringungsbereichen (6) verbundene Wärmeleitbrücken (11) besitzt, die aus einem Material mit höherer Wärmeleitfähigkeit bestehen als das Substratmaterial und die die Substratvorderseite mit der Substratrückseite wärmeleitend verbinden, umfassend die Schritte:
- Einsetzen des Chipmoduls (1) in die Ausnehmung (20) des Chipkartenkörpers (21) derart, daß ein die Wärmeleitbrücken (11) aufweisender Teil der Substratrückseite über einen wärmeaktivierbaren Klebstoff (10) mit einem Boden oder einer Auflageschulter (22) der Ausnehmung (20) in Kontakt kommt, und
- Aufbringen von Wärme auf das Chipmodul von der Substratvorderseite des Chipmoduls (1) aus in die Wärmeeinbringungsbereiche (6),
wobei das Chipmodul (1) so in die Ausnehmung (20) eingesetzt wird, daß die Wärmeleitbrücken (11) beim späteren Betrieb der Chipkarte keine elektrisch leitende Funktion übernehmen.

17. Verfahren nach Anspruch 16, **dadurch gekennzeichnet, daß** als Chipmodul (1) ein Chipmodul nach einem der Ansprüche 1 bis 10 gewählt wird.

## Claims

1. A chip module (1) for installation into a recess (20) of a chip card body (21) by means of a heat-activatable adhesive (10), comprising a substrate (2) with contact areas (4) in a central region of the substrate front side for the contact-type contacting of the chip module and with heat introduction regions configured in an edge area (6) of the substrate front side for the introduction of heat into the chip module (1) and furthermore comprising a chip (7) electro-conductively connected with the contact areas (4), **characterized in that**
- the heat introduction regions (6) are separate from the contact areas (4) and do not serve as an electrical conductor,
- in the substrate (2) there are configured one or several heat conducting bridges (11) which consist of a material with higher thermal conductivity than the substrate material, and
- the heat conducting bridges (11) heat-conductively connect the heat introduction regions (6) on the substrate front side with a back side of the substrate (2).

2. The chip module according to claim 1, **characterized in that** the heat introduction regions are configured separately from the contact areas (4).

3. The chip module according to claim 1, **characterized in that** the heat introduction regions comprise the same material as the contact areas (4), but are separate from the contact areas (4) by a material interruption (5).

4. The chip module according to any of claims 1 to 3, **characterized in that** the thermal conductivity of the material of the heat conducting bridges (11) is more than 100, preferably more than 1000 times greater than the thermal conductivity of the substrate material.

5. The chip module according to any of claims 1 to 4, **characterized in that** the heat conducting bridges (11) consist of metal, in particular copper.

6. The chip module according to any of claims 1 to 5, **characterized in that** the heat conducting bridges (11) between the substrate front side and the substrate back side are led through the substrate (2).

7. The chip module according to any of claims 1 to 6, **characterized in that** the heat conducting bridges (11) are heat-conductively connected with heat transfer zones (12a, 12b) which are configured on the substrate back side and likewise consist of a material with higher thermal conductivity than the substrate material.

8. The chip module according to claim 7, **characterized in that** the heat transfer zones (12a, 12b) consist of the same material as electrical conducting paths or terminals configured on the substrate back side, but are arranged separate therefrom.

9. The chip module according to any of claims 7 or 8, **characterized in that** the heat transfer zones (12b) extend in a meandering form.

10. The chip module according to any of claims 7 or 8, **characterized in that** several heat transfer zones (12a) are configured as stripes running side by side, which are respectively connected with at least one heat conducting bridge (11).

11. The chip module according to any of claims 1 to 10, **characterized by** a heat-activatable adhesive (10) on the substrate back side.

12. A chip card comprising a card body (21) with a recess (20) in which there is arranged a chip module (1) which has a substrate (2) with an outwardly pointing front side on which there are provided contact areas (4) for the contact-type contacting of the chip card, and a back side by means of which the chip module (1) is glued in the recess (20), **characterized in that**
- on the front side of the substrate (2) there are configured heat introduction regions (6) separate from the contact areas (4),
- in the substrate there are configured one or several heat conducting bridges (11) which consist of a material with higher thermal conductivity than the substrate material, and
- the heat conducting bridges (11) heat-conductively connect the substrate front side with the substrate back side, wherein the heat conducting bridges (11) do not assume any electro-conductive function upon operation of the chip card.

13. The chip card according to claim 12, **characterized in that** the heat conducting bridges (11) are arranged beside the contact areas (4) in an edge area (6) of the substrate front side.

14. The chip card according to claim 12 or 13, **characterized in that** at least one or several of the heat conducting bridges (11) are arranged in the region of the contact areas (4).

15. The chip card according to any of claims 12 to 14, **characterized in that** the chip module (1) is a chip module according to any of claims 1 to 10.

16. A method for installing a chip module (1) into a recess of a chip card body (21) wherein the chip module (1) has a substrate (2) with a front side on which there are provided contact areas (4) for the contact-type contacting of the chip card and at least one heat introduction region (6) separate therefrom, and a back side by means of which the chip module (1) is glued into the recess (20), and holds one or several heat conducting bridges (11) connected with the at least one heat introduction regions (6), which heat conducting bridges consist of a material with higher thermal conductivity than the substrate material and which heat-conductively connect the substrate front side with the substrate back side, comprising the steps:
- inserting the chip module (1) into the recess (20) of the chip card body (21) such that a part of the substrate back side having the heat conducting bridges (11) comes into contact with a bottom or a rest shoulder (22) of the recess (20) via a heat-activatable adhesive (10), and
- applying heat onto the chip module from the substrate front side of the chip module (1) into the heat introduction regions (6), wherein the chip module (1) is inserted into the recess (20) such that the heat conducting bridges (11) do not assume any electro-conductive function upon the later operation of the chip card.

17. The method according to claim 16, **characterized in that** as a chip module (1) there is selected a chip module according to any of claims 1 to 10.

## Revendications

1. Module puce (1) destiné à être encastré dans un évidement (20) d'un corps de carte à puce (21) au moyen d'une colle (10) thermoactivable, comprenant un substrat (2) ayant des surfaces de contact (4) dans un zone centrale de la face avant du substrat aux fins d'une connexion du module puce avec contact et ayant des zones d'apport de chaleur réalisées dans une zone de bordure (6) de la face avant du substrat aux fins de l'apport de chaleur dans le module puce (1), et comprenant en outre une puce (7) reliée de manière électroconductrice aux surfaces de contact (4), **caractérisé en ce que**
- les zones d'apport de chaleur (6) sont séparées des surfaces de contact (4) et ne servent pas de conducteur électrique,
- dans le substrat (2), un ou plusieurs ponts thermoconducteurs (11) sont réalisés, lesquels consistent en un matériau ayant une conductivité thermique supérieure à celle du matériau du substrat, et
- les ponts thermoconducteurs (11) relient de manière conduisant la chaleur les zones d'apport de chaleur (6) situées sur la face avant du substrat avec une face arrière du substrat (2).

2. Module puce selon la revendication 1, **caractérisé en ce que** les zones d'apport de chaleur sont réalisées de manière séparée des surfaces de contact (4).

3. Module puce selon la revendication 1, **caractérisé en ce que** les zones d'apport de chaleur comprennent le même matériau que les surfaces de contact (4) mais sont cependant séparées des surfaces de contact (4) par une interruption de matériau (5).

4. Module puce selon une des revendications de 1 à 3, **caractérisé en ce que** la conductivité thermique du matériau des ponts thermoconducteurs (11) est de 100 fois supérieure, de préférence de 1000 fois supérieure à la conductivité thermique du matériau du substrat.

5. Module puce selon une des revendications de 1 à 4, **caractérisé en ce que** les ponts thermoconducteurs (11) consistent en du métal, en particulier en du cuivre.

6. Module puce selon une des revendications de 1 à 5, **caractérisé en ce que** les ponts thermoconducteurs (11) sont placés de telle sorte entre la face avant du substrat et la face arrière du substrat qu'ils traversent le substrat (2).

7. Module puce selon une des revendications de 1 à 6, **caractérisé en ce que** les ponts thermoconducteurs (11) sont reliés de manière conduisant la chaleur avec des zones de transmission de chaleur (12a, 12b) qui sont réalisées sur la face arrière du substrat et qui consistent aussi en un matériau ayant une conductivité supérieure à celle du matériau du substrat.

8. Module puce selon la revendication 7, **caractérisé en ce que** les zones de transmission de chaleur (12a, 12b) consistent en le même matériau que des pistes conductives électriques ou bornes réalisées sur la face arrière du substrat, mais sont néanmoins agencées de manière séparée de ces dernières.

9. Module puce selon une des revendications 7 ou 8, **caractérisé en ce que** les zones de transmission de chaleur (12b) décrivent un tracé en méandres.

10. Module puce selon une des revendications 7 ou 8, **caractérisé en ce que** plusieurs zones de transmission de chaleur (12a) sont réalisées sous forme de rubans qui s'étendent les uns à côté des autres et sont respectivement reliés par au moins un pont thermoconducteur (11).

11. Module puce selon une des revendications de 1 à 10, **caractérisé par** une colle thermoactivable (10) sur la face arrière du substrat.

12. Carte à puce comprenant un corps de carte (21) ayant un évidement (20) dans lequel un module puce (1) est agencé, lequel comporte un substrat (2) ayant une face avant tournée vers l'extérieur et sur laquelle des surfaces de contact (4) destinées à la connexion de la carte à puce avec contact sont prévues, et ayant une face arrière par laquelle le module puce (1) est collé dans l'évidement (20), **caractérisée en ce que**
- sur la face avant du substrat (2), des zones d'apport de chaleur (6) séparées des surfaces de contact (4) sont réalisées,
- dans le substrat, un ou plusieurs ponts thermoconducteurs (11) consistant en un matériau possédant une conductivité thermique supérieure à celle du matériau du substrat sont réalisés, et
- les ponts thermoconducteurs (11) relient de manière conduisant la chaleur la face avant du substrat avec la face arrière du substrat, les ponts thermoconducteurs (11) n'exerçant pas de fonction électroconductrice lors du fonctionnement de la carte à puce.

13. Carte à puce selon la revendication 12, **caractérisée en ce que** les ponts thermoconducteurs (11) sont agencés dans une zone de bordure (6) de la face avant du substrat, à côté des surfaces de contact (4).

14. Carte à puce selon la revendication 12 ou 13, **caractérisée en ce qu**'au moins ou plusieurs des ponts thermoconducteurs (11) sont agencés dans la zone des surfaces de contact (4).

15. Carte à puce selon une des revendications de 12 à 14, **caractérisée en ce que** le module puce (1) est un module puce conforme à une des revendications de 1 à 10.

16. Procédé d'encastrement d'un module puce (1) dans un évidement d'un corps de carte à puce (21), le module puce (1) comportant un substrat (2) ayant une face avant, sur laquelle des surfaces de contact (4) destinées à la connexion de la carte puce avec contact ainsi qu'au moins une zone d'apport de chaleur (6) en étant séparée sont prévues, et ayant une face arrière par laquelle le module puce (1) est collé dans l'évidement (20), et possédant un ou plusieurs ponts thermoconducteurs (11), lesquels sont reliés à la au moins une zone d'apport de chaleur (6), consistent en un matériau ayant une conductivité thermique supérieure à celle du matériau du substrat, et relient de manière conduisant la chaleur la face avant du substrat avec une face arrière du substrat, comprenant les étapes :
- insertion du module puce (1) dans un évidement (20) du corps de carte à puce (21), de telle façon qu'une partie de la face arrière du substrat sur laquelle se trouvent les ponts thermoconducteurs (11) entre en contact, par l'intermédiaire d'une colle (10) thermoactivable, avec un fond ou un épaulement d'appui (22) de l'évidement (20), et
- application de chaleur sur le module puce, à partir de la face avant du substrat du module puce (1), dans les zones d'apport de chaleur (6), le module puce (1) étant inséré de telle manière dans l'évidement (20) que les ponts thermoconducteurs (11) n'exercent pas de fonction electroconductrice lors du fonctionnement ultérieur de la carte à puce.

17. Procédé selon la revendication 16, **caractérisée en ce que,** en tant que module puce (1), c'est un module puce conforme à une des revendications de 1 à 10 qui est choisi.
